# EUROPEAN PATENT APPLICATION

(11) **EP 4 845 363 A1**
(43) Date of publication of application: **25.11.2026**
(21) Application number: 25757557.1
(22) Date of filing: 07.01.2025
(51) Int. Cl.: H10K 30/57, H10K 30/15

(54) **LAMINATED SOLAR CELL, PHOTOVOLTAIC MODULE, POWER GENERATION DEVICE AND ELECTRIC DEVICE**

(30) Priority: 23.02.2024 CN 202420343282 U
(71) Applicant: Contemporary Amperex Technology Co., Limited, Ningde, Fujian 352100 (CN)
(72) Inventor: ZHOU, Zichun, Ningde, Fujian 352100 (CN); PAN, Haixi, Ningde, Fujian 352100 (CN); ZHOU, Hongmei, Ningde, Fujian 352100 (CN); WANG, Shidan, Ningde, Fujian 352100 (CN); SU, Shuojian, Ningde, Fujian 352100 (CN); OUYANG, Chuying, Ningde, Fujian 352100 (CN)
(74) Representative: Lorenz Seidler Gossel Part. mbB
(86) International application number: PCT/CN2025/070966
(87) International publication number: WO 2025/175959

(57) **Abstract**

Provided in the present disclosure are a laminated solar cell, a photovoltaic module and an electric device. The laminated solar cell comprises a first electrode and a second electrode, at least two cell units arranged between the first electrode and the second electrode, and a composite layer, wherein the at least two cell units include a first cell unit and a second cell unit, which are sequentially arranged in a first direction, the composite layer is arranged between the first cell unit and the second cell unit, and the first direction is an incident direction of light; the second cell unit comprises a second hole transport layer, a second light absorption layer and a second electron transport layer, which are sequentially arranged in the first direction; and the second cell unit further comprises an electron barrier layer arranged between the second hole transport layer and the second light absorption layer.

## Description

### CROSS-REFERENCE TO RELATED APPLICATIONS

The present disclosure is based on and claims priority to the Chinese Patent Application No. 202420343282.4, filed on February 23, 2024, entitled "TANDEM SOLAR CELL, PHOTOVOLTAIC MODULE, POWER GENERATION APPARATUS AND ELECTRIC APPARATUS", which is incorporated herein by reference in its entirety.

### TECHNICAL FIELD

The present disclosure relates to the field of battery technologies, and in particular, to a tandem solar cell, a photovoltaic module, a power generation apparatus, and an electric apparatus.

### BACKGROUND

A solar cell, also known as a photovoltaic cell, is an apparatus that directly converts light energy into electrical energy through the photoelectric effect or photochemical effect. As an ideal renewable energy source, solar cells have received increasing attention.

With the development of solar cell technology, people have increasingly higher performance requirements for solar cells. Tandem solar cells have good application prospects because of their high photoelectric conversion efficiency.

For tandem solar cells, especially all-perovskite tandem solar cells, a bottom cell unit generally has a wide bandgap, and a top cell unit has a narrow bandgap. Limited by a bandgap of the light absorption layer in the top cell unit, a material used for a hole transport layer in the top cell unit mainly includes an organic hole transport material, resulting in a low thickness of the hole transport layer. Due to the thickness limitation, the electron blocking effect of the hole transport layer is limited, and non-radiative recombination of holes and electrons still occurs in the top cell unit, which limits improvement of the photoelectric conversion efficiency of the tandem solar cell.

### SUMMARY

The present disclosure is made in view of the above subject, and its purpose is to provide a tandem solar cell, a photovoltaic module, and a photovoltaic apparatus. In the tandem solar cell, multi-layer blocking of electrons in a second cell unit can be realized by arranging an electron barrier layer and a second hole transport layer in the second cell unit, strengthening the electron blocking effect, reducing the non-radiative recombination of electrons and holes, thereby optimizing an open circuit voltage and improving photoelectric conversion efficiency of the tandem solar cell.

In order to achieve the above purpose, the present disclosure provides a tandem solar cell. The tandem solar cell includes a first electrode and a second electrode, at least two cell units arranged between the first electrode and the second electrode, and a composite layer; the at least two cell units include a first cell unit and a second cell unit arranged sequentially along a first direction, and the composite layer is arranged between the first cell unit and the second cell unit, where the first direction is a light incident direction; where the second cell unit includes a second hole transport layer, a second light absorption layer, and a second electron transport layer that are arranged sequentially along the first direction; and the second cell unit further includes an electron barrier layer arranged between the second hole transport layer and the second light absorption layer. In the present disclosure, on the basis of the second hole transport layer, multi-layer blocking of electrons in the second cell unit can be realized with the electron barrier layer. This strengthens the electron blocking effect and reduces the non-radiative recombination of electrons and holes, thereby optimizing the open circuit voltage and improving photoelectric conversion efficiency of the tandem solar cell.

In some embodiments, a thickness of the electron barrier layer is 1 nm to 25 nm, optionally 1 nm to 20 nm. By setting the thickness of the electron barrier layer to the above range, the electron barrier layer can exert the electron blocking effect while incurring low light absorption, which helps reduce the absorption of sunlight by the electron barrier layer.

In some embodiments, the thickness of the electron barrier layer is 5 nm to 20 nm. By setting the thickness of the electron barrier layer to the above range, the open circuit voltage can be further optimized and photoelectric conversion efficiency of the tandem solar cell can be further improved.

In some embodiments, the electron barrier layer is arranged as a film layer structure or island-distributed nanoparticles. By arranging the electron barrier layer as a film layer structure, the transport of electrons can be further blocked. By arranging the electron barrier layer as island-distributed nanoparticles, the lateral transport of holes can be reduced, which helps improve the utilization of holes.

In some embodiments, a median particle size of the nanoparticles is 1 nm to 30 nm. By setting the median particle size of the nanoparticles to the above range, the aggregation of the nanoparticles can be alleviated, which helps further reduce the lateral transport of holes. Further, the median particle size of the nanoparticles is 1 nm to 20 nm, further optionally 5 nm to 20 nm. The aggregation of the nanoparticles can be further reduced, which helps reduce the lateral transport of holes.

In some embodiments, a thickness of the second hole transport layer is 5 nm to 10 nm. By arranging the electron barrier layer and the second hole transport layer, multi-layer blocking of electrons in the second cell unit can be realized. Even if the thickness of the second hole transport layer is within the above range, a strong electron blocking effect can still be achieved in the second cell unit.

In some embodiments, the first cell unit is arranged on the first electrode and includes a first hole transport layer, a first light absorption layer, a first hole blocking layer, a first electron transport layer, and a second hole blocking layer that are arranged sequentially along the first direction. With the first hole blocking layer and the second hole blocking layer, multi-layer blocking of holes in the first cell unit can be realized, the hole blocking effect can be strengthened, and the non-radiative recombination of holes and electrons can be further reduced, thereby optimizing the open circuit voltage and improving photoelectric conversion efficiency of the tandem solar cell.

In some embodiments, the second cell unit further includes a third hole blocking layer arranged between the second light absorption layer and the second electron transport layer. The blocking effect of the third hole blocking layer on holes can further reduce the non-radiative recombination of electrons and holes.

In some embodiments, the second cell unit further includes a fourth hole blocking layer arranged between the second electron transport layer and the second electrode. With the first hole blocking layer, the second hole blocking layer, the third hole blocking layer, and/or the fourth hole blocking layer, multi-layer blocking of holes can be realized, and the hole blocking effect can be strengthened, thereby further optimizing the open circuit voltage and improving photoelectric conversion efficiency of the tandem solar cell.

In some embodiments, a resistivity of the electron barrier layer is greater than or equal to 10¹² Ω·m, optionally greater than or equal to 10¹² Ω·m and less than or equal to 10¹⁸ Ω·m. The above electron barrier layer has a strong electron blocking effect.

In some embodiments, a material of the electron barrier layer includes a material of the electron barrier layer includes at least one of an inorganic electron blocking material and an organic electron blocking material.

In some embodiments, the material of the electron barrier layer includes at least one of an inorganic oxide, an inorganic nitride, an inorganic carbide, an inorganic silicide, an inorganic sulfide, and a carbon material. Using at least one of the inorganic oxide, inorganic nitride, inorganic carbide, inorganic silicide, inorganic sulfide, and carbon material as the electron barrier layer material can strengthen the electron blocking effect and thereby reduce the non-radiative recombination of electrons and holes.

In some embodiments, the tandem solar cell satisfies one or more of the following conditions:
(1) the inorganic oxide includes one or more of antimony oxide, aluminum oxide, cobalt oxide, boron oxide, bismuth oxide, chromium trioxide, copper oxide, magnesium oxide, molybdenum trioxide, silicon dioxide, vanadium oxide, and zirconium oxide;
(2) the inorganic nitride includes one or more of aluminum nitride, aluminum nitride, boron nitride, calcium nitride, chromium nitride, europium nitride, magnesium nitride, silicon nitride, titanium nitride, vanadium nitride, zirconium nitride, and gallium nitride;
(3) the inorganic carbide includes one or more of aluminum carbide, boron carbide, chromium carbide, molybdenum carbide, silicon carbide, titanium carbide, vanadium carbide, tungsten carbide, and zirconium carbide;
(4) the inorganic silicide includes one or more of cobalt silicide, magnesium silicide, molybdenum silicide, niobium silicide, titanium silicide, tungsten silicide, and zirconium silicide;
(5) the inorganic sulfide includes one or more of aluminum sulfide, antimony sulfide, bismuth sulfide, barium sulfide, boron sulfide, calcium sulfide, chromium sulfide, cobalt sulfide, europium sulfide, gallium sulfide, magnesium sulfide, molybdenum sulfide, silicon disulfide, tungsten sulfide, vanadium sulfide, and zirconium sulfide; and
(6) the organic electron blocking material includes one or more of diphenylamino carbazole and methyl triphenylamine carboxylic acid.

In some embodiments, a bandgap of the second light absorption layer is narrower than a bandgap of the first light absorption layer.

In some embodiments, the tandem solar cell satisfies one or more of the following conditions:
(1) the first light absorption layer includes a perovskite material;
(2) the bandgap of the first light absorption layer is 1.6 eV to 2.3 eV;
(3) the second light absorption layer includes a perovskite material; and
(4) the bandgap of the second light absorption layer is 1.1 eV to 1.4 eV.

The bandgap of the first light absorption layer is 1.6 eV to 2.3 eV. As a wide-bandgap cell unit, it helps to absorb short-wavelength light. The bandgap of the second light absorption layer is 1.1 eV to 1.4 eV. As a narrow-bandgap cell unit, it helps to absorb long-wavelength light. The two can increase a spectral width for light absorption of the tandem solar cell and improve the photoelectric conversion efficiency of the tandem solar cell. The first light absorption layer and/or the second light absorption layer include perovskite materials. Compared with other tandem solar cells, the photoelectric conversion efficiency of the tandem solar cell is further improved, and the costs are lower.

According to a second aspect of the present disclosure, a photovoltaic module is provided, where the photovoltaic module includes the tandem solar cell provided in the first aspect.

According to a third aspect of the present disclosure, a power generation apparatus is provided, where the power generation apparatus includes the tandem solar cell provided in the first aspect.

According to a fourth aspect of the present disclosure, an electric apparatus is provided, where the electric apparatus includes the tandem solar cell provided in the first aspect.

### BRIEF DESCRIPTION OF DRAWINGS

FIG. 1 is a schematic structural diagram of a tandem solar cell according to an embodiment of the present disclosure.
FIG. 2 is a schematic structural diagram of a tandem solar cell according to an embodiment of the present disclosure.
FIG. 3 is a schematic structural diagram of a tandem solar cell according to an embodiment of the present disclosure.
FIG. 4 is a schematic structural diagram of a tandem solar cell according to an embodiment of the present disclosure.

### Description of reference signs:

10, 100, 200, 300 tandem solar cell; 11 first electrode; 12 second electrode; 13 first cell unit; 131 first hole transport layer; 132 first light absorption layer; 133 first hole blocking layer; 134 first electron transport layer; 135 second hole blocking layer; 14 second cell unit; 141 second hole transport layer; 142 second light absorption layer; 143 second electron transport layer; 144 electron barrier layer; 145 third hole blocking layer; 146 fourth hole blocking layer; and 15 composite layer.

### DESCRIPTION OF EMBODIMENTS

Hereinafter, embodiments of a tandem solar cell, a photovoltaic module, a power generation apparatus, and an electric apparatus in the present disclosure are specifically disclosed in detail with appropriate reference to the drawings. However, unnecessary detailed descriptions may be omitted. For example, detailed descriptions of well-known matters and repeated descriptions of substantially the same structures may be omitted. This is to avoid the following descriptions from becoming unnecessarily lengthy and to facilitate understanding by those skilled in the art. In addition, the drawings and the following descriptions are provided for those skilled in the art to fully understand the present disclosure and are not intended to limit the subject matter described in the claims.

The "range" disclosed in the present disclosure is defined in the form of a lower limit and an upper limit. A given range is defined by a lower limit and an upper limit, and the selected lower limit and upper limit define the boundaries of a particular range. The range defined in this way may include or exclude the end values and may be arbitrarily combined, that is, any lower limit may be combined with any upper limit to form a range. For example, if ranges of 60 to 120 and 80 to 110 are listed for a specific parameter, it is understood that the ranges of 60 to 110 and 80-120 are also contemplated. In addition, if the minimum range values 1 and 2 are listed, and if the maximum range values 3, 4, and 5 are listed, the following ranges can all be contemplated: 1 to 3, 1 to 4, 1 to 5, 2 to 3, 2 to 4, and 2 to 5. In the present disclosure, unless otherwise stated, the numerical range "a to b" represents an abbreviated representation of any real number combination between a and b, where a and b are both real numbers. For example, the numerical range "0-5" means that all real numbers between "0 to 5" have been fully listed herein, and "0 to 5" is only an abbreviated representation of these numerical combinations. In addition, when it is stated that a certain parameter is an integer greater than or equal to 2, it is equivalent to disclosing that the parameter is, for example, an integer 2, 3, 4, 5, 6, 7, 8, 9, 10, 11, 12, or the like.

If there is no special description, all embodiments and optional embodiments of the present disclosure can be combined with each other to form new technical solutions.

If there is no special description, all technical features and optional technical features of the present disclosure can be combined with each other to form new technical solutions.

If there is no special description, all steps of the present disclosure can be carried out sequentially or randomly, and are preferably carried out sequentially. For example, a method includes steps (a) and (b), which means that the method may include steps (a) and (b) carried out sequentially, or may include steps (b) and (a) carried out sequentially. For example, it is mentioned that the method may further include step (c), which means that step (c) may be added to the method in any position. For example, the method may include steps (a), (b), and (c), may also include steps (a), (c), and (b), and may also include steps (c), (a), and (b), and the like.

If there is no special description, the terms used in the present disclosure have the well-known meanings generally understood by those skilled in the art.

If there is no special description, the values of the parameters mentioned in the present disclosure can be measured by various test methods commonly used in the art. For example, they can be measured according to the test methods given in the present disclosure.

The term "layer" used in the present disclosure refers to any structure that is substantially layered. A layer may have a thickness that varies across the extent of the layer. Usually, a thickness of a layer is approximately constant. The "thickness" of a layer used in the present disclosure refers to an average thickness of the layer. The thickness of a layer can be easily measured using conventional methods.

If there is no special description, the description in the present disclosure that one layer is/located on another layer includes a case that a first layer is directly located on the second layer, that is, the two layers are in direct contact, and a case that another interposed layer (such as a third layer) is between the first layer and the second layer.

The term "perovskite" used in the present disclosure refers to a material having a three-dimensional crystal structure related to the three-dimensional crystal structure of CaTiO₃, or a layered material including a structure related to the structure of CaTiO₃. Materials having a three-dimensional crystal structure related to the three-dimensional crystal structure of CaTiO₃ are well known and may be referred to as perovskites having a "3D perovskite structure" or "3D perovskites". Materials containing a perovskite material layer are well known. When receiving sunlight, electrons in the perovskite are excited, and the electrons transition from the valence band to the conduction band, generating electron-hole pairs. If there is no special description, the "perovskite" mentioned in the present disclosure refers to a 3D perovskite material.

A chemical general formula of the perovskite material may be expressed as ABX₃ or A₂CDX₆. The A ion is a monovalent cation, the B ion is a divalent metal cation, the C ion is a monovalent metal cation, the D ion is a trivalent metal cation, and the X ion is a monovalent anion. When the perovskite includes more than one type of A cation, different A cations may be distributed in an ordered or disordered manner on A sites. When the perovskite includes more than one type of B cation, different B cations may be distributed in an ordered or disordered manner on B sites. When the perovskite includes more than one type of X anion, different X anions may be distributed in an ordered or disordered manner on the X sites.

Optionally, the A ion is a monovalent cation with a larger radius, including at least one of organic cation and metal cation. More optionally, the organic cation includes at least one of organic amine ion, formamidinium (HC(NH₂)₂⁺, FA⁺), and imidazolium; more optionally, the metal cation includes at least one of Li⁺, sodium ion (Na⁺), potassium ion (K⁺), rubidium ion (Rb⁺), and cesium ion (Cs⁺). Further, the organic amine ion includes at least one of methylammonium (CH₃NH₃⁺, MA⁺), methylenediammonium ion (MDA²⁺), phenethylammonium ion (PEA⁺), oleylammonium ion (OA⁺), ethylammonium, propylammonium, butylammonium, pentylammonium, and hexylammonium.

Optionally, the B ion includes at least one of Pb²⁺ (lead ion), Sn²⁺ (tin ion), Be²⁺ (beryllium ion), Mg²⁺ (magnesium ion), Ca²⁺ (calcium ion), Sr²⁺ (strontium ion), Ba²⁺ (barium ion), Zn²⁺ (zinc ion), Ge²⁺ (germanium ion), Fe²⁺ (ferrous ion), Co²⁺ (divalent cobalt ion), Cu²⁺ (divalent copper ion), and Ni²⁺ (divalent nickel ion); more optionally, the B ion includes one or both of Pb²⁺ (lead ion) and Sn²⁺ (tin ion).

Optionally, the C ion includes at least one of Cs⁺ (cesium ion), Ag⁺ (silver ion), K⁺ (potassium ion), and Rb⁺ (rubidium ion).

Optionally, the D ion includes at least one of Bi³⁺ (bismuth ion), Ni³⁺ (trivalent nickel ion), Fe³⁺ (trivalent iron ion), and Cu³⁺ (trivalent copper ion).

Optionally, the X ion includes at least one of fluoride ion (F⁻), chloride ion (Cl⁻), bromide ion (Br⁻), iodide ion (I⁻), thiocyanate ion (SCN⁻), fulminate ion (CNO⁻), cyanate ion (OCN⁻), thiocyanate ion (OSCN⁻), hydrosulfide ion (SH⁻), cyanide ion (CN⁻), and selenocyanate ion (SeCN⁻); optionally, the X ion includes at least one of Cl⁻, Br⁻, and I⁻.

A solar cell, also known as a photovoltaic cell, is an apparatus that directly converts light energy into electrical energy through the photoelectric effect or photochemical effect. As an ideal renewable energy source, solar cells have received increasing attention.

With the development of solar cell technology, people have increasingly higher performance requirements for solar cells. A tandem solar cell includes at least two cell units that are stacked. Through the combination of bandgaps of the cell units, the absorption of sunlight in a wide wavelength range is realized, and the utilization of sunlight is improved. Therefore, tandem solar cells have high photoelectric conversion efficiency.

Each cell unit in a tandem solar cell is provided with a light absorption layer and a carrier transport layer (for example, an electron transport layer and a hole transport layer). The light absorption layer uses a light-absorbing material (for example, a perovskite material) that can absorb photons to generate electron-hole pairs. Under the action of an electric field, the electron-hole pairs are dissociated into carriers (electrons and holes). The directional movement of the dissociated carriers forms a current. The presence of the carrier transport layer can enhance the dissociation effect of electrons and holes, thereby effectively improving the photoelectric conversion efficiency of the cell.

For tandem solar cells, especially all-perovskite tandem solar cells, a bottom cell unit (also referred to herein as a first cell unit, which refers to a cell unit that first receives incident light) generally has a wide bandgap, and a top cell unit (also referred to herein as a second cell unit, which refers to a cell unit that receives incident light passing through the bottom cell unit) has a narrow bandgap. When a perovskite cell unit is used as the second cell unit, a bandgap of a light absorption layer (also referred to herein as a second light absorption layer) is 1.1 eV to 1.4 eV.

A bandgap is equal to a difference between a LUMO energy level and a HOMO energy level. Since a narrower bandgap of the second light absorption layer leads to a more positive HOMO energy level of the second light absorption layer, a hole transport material capable of band alignment is mainly an organic hole transport material, and therefore the thickness of the second hole transport layer usually is 5 nm to 10 nm. Due to the thickness limitation, the electron blocking effect of the second hole transport layer is limited, and non-radiative recombination of holes and electrons still occurs in the second cell unit of the perovskite cell unit, which limits the photoelectric conversion efficiency of the tandem solar cell and there is still room for improvement.

In view of this, the embodiments of the present disclosure provide a tandem solar cell. A photovoltaic module is provided, and a power generation apparatus and electric apparatus that include the tandem solar cell are also provided. The tandem solar cell can realize multi-layer blocking of electrons in the second cell unit of the perovskite cell unit by arranging an electron barrier layer and a second hole transport layer in the second cell unit, which strengthens the electron blocking effect, reduces the non-radiative recombination of electrons and holes, thereby optimizing the open circuit voltage and improving photoelectric conversion efficiency of the tandem solar cell.

### Tandem solar cell

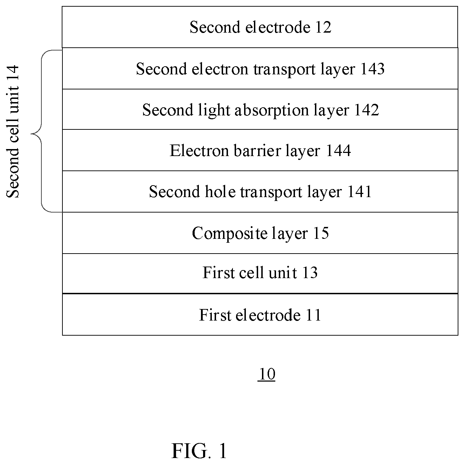

FIG. 1 is a schematic diagram of a tandem solar cell according to an embodiment of the present disclosure. The tandem solar cell 10 includes a first electrode 11 and a second electrode 12; at least two cell units and a composite layer 15 arranged between the first electrode 11 and the second electrode 12, and the at least two cell units include a first cell unit 13 and a second cell unit 14 arranged sequentially along a first direction; the composite layer 15 is arranged between the first cell unit 13 and the second cell unit 14, where the first direction is the incident direction of light; where the second cell unit 14 includes a second hole transport layer 141, a second light absorption layer 142, and a second electron transport layer 143 arranged sequentially along the first direction; and the second cell unit 14 further includes an electron barrier layer 144 arranged between the second hole transport layer 141 and the second light absorption layer 142.

In the present disclosure, on the basis of the second hole transport layer 141, multi-layer blocking of electrons in the second cell unit 14 can be realized with the electron barrier layer 144. This strengthens the electron blocking effect and reduces the non-radiative recombination of electrons and holes, thereby optimizing the open circuit voltage and improving photoelectric conversion efficiency of the tandem solar cell.

The term "tandem solar cell" in the present disclosure refers to a solar cell having a structure in which at least two cell units are arranged sequentially along a light incident direction. With at least two stacked cell units, the utilization of incident sunlight can be increased.

The present disclosure does not particularly limit a quantity of cell units included in the tandem solar cell 10. For example, 2, 3, 4, or more cell units may be included in the tandem solar cell.

In the following text, the description is made by taking the tandem solar cell 10 including two cell units (the first cell unit 13 and the second cell unit 14) as an example.

The first electrode 11 is made of a material including a transparent conductive material. The present disclosure does not particularly limit the transparent conductive material included in the first electrode 11. For example, the transparent conductive material includes at least one of indium tin oxide, fluorine-doped tin oxide (TCO), antimony-doped tin oxide, indium-doped tungsten oxide, indium-doped zinc oxide, aluminum-doped zinc oxide, and boron-doped zinc oxide.

The thickness of the first electrode 11 is not particularly limited in the present disclosure, and may be the electrode thickness commonly used in the art. For example, the thickness of the first electrode 11 may be 10 nm to 800 nm.

The second electrode 12 is made of a material including a conductive material. The present disclosure does not particularly limit the conductive material included in the second electrode 12. For example, the conductive material includes at least one of the above transparent conductive material, metals and their alloys, and carbon elemental material. For example, the metals and their alloys include at least one of gold, silver, copper, aluminum, nickel, chromium, bismuth, platinum, magnesium, molybdenum, and tungsten. For example, the carbon elemental materials include at least one of graphite, graphene, and carbon nanotubes.

The thickness of the second electrode 12 is not particularly limited in the present disclosure, and may be the electrode thickness commonly used in the art. For example, the thickness of the second electrode 12 may be 10 nm to 100 nm.

The composite layer 15 is arranged between the first cell unit 13 and the second cell unit 14 and is configured to provide a site for the recombination of electrons generated by excitation in the first cell unit 13 and holes generated by excitation in the second cell unit 14. The present disclosure does not particularly limit the material contained in the composite layer 15. For example, the composite layer 15 includes at least one of gold, platinum, indium tin oxide, indium zinc oxide, iron, cobalt, nickel, zinc, manganese, cadmium, silver, and copper. The thickness of the composite layer 15 is not particularly limited in the present disclosure, and may be the composite layer thickness commonly used in the art.

The first cell unit 13 is arranged on the first electrode 11. The first cell unit 13 may have a relatively wide bandgap (for example, a bandgap of 1.6 eV to 2.3 eV), which helps the first cell unit 13 and the second cell unit 14 with a narrow bandgap to form a tandem solar cell 10 with high photoelectric conversion efficiency. In a specific example, the first cell unit is a perovskite solar cell.

In the present disclosure, the second cell unit 14 is arranged on the composite layer 15 and includes a second hole transport layer 141, a second light absorption layer 142, a second electron transport layer 143 arranged sequentially along the first direction, and an electron barrier layer 144 arranged between the second hole transport layer 141 and the second light absorption layer 142.

The second hole transport layer 141 is arranged between the composite layer 15 and the second light absorption layer 142 and is configured to transport the holes generated by excitation in the second light absorption layer 142 to the composite layer 15. Limited by the bandgap of the second light absorption layer 142, the material used for the second hole transport layer 141 is mostly an organic hole transport material. For example, the organic hole transport material includes at least one of [2-(3,6-dimethoxy-9H-carbazol-9-yl)butyl]phosphoric acid, poly(3,4-ethylenedioxythiophene), polystyrene sulfonate, polystyrene sulfonic acid, poly(3-hexylthiophene), triptycene-centered triphenylamine, 3,4-ethylenedioxythiophene-methoxy triphenylamine, N-(4-anilino)carbazole-spirobifluorene, and polythiophene.

In some embodiments, the thickness of the second hole transport layer 141 is 5 nm to 10 nm. For example, the thickness of the second hole transport layer is 5 nm, 6 nm, 7 nm, 8 nm, 9 nm, 10 nm, or a value between any two numerical values, but is not limited thereto. By arranging the electron barrier layer 144 and the second hole transport layer 141, multi-layer blocking of electrons in the second cell unit 14 can be realized. Even if the thickness of the second hole transport layer 141 is within the above range, a strong electron blocking effect can still be achieved in the second cell unit 14.

The second light absorption layer 142 is made of a material including a second light-absorbing material. The second light-absorbing material includes a perovskite material. With a designed perovskite material, the second light absorption layer 142 can have a relatively narrow bandgap, which helps the second cell unit 14 and the first cell unit 13 with a wide bandgap to form a tandem solar cell with high photoelectric conversion efficiency.

In some embodiments, the bandgap of the second light absorption layer 142 is 1.1 eV to 1.4 eV. The perovskite material used for the second light absorption layer 142 is, for example, MA_{0.3}FA_{0.7}Pb_{0.5}Sn_{0.5}I₃, MAPb_{0.85}Sn_{0.15}I₃, FAPb_{0.5}Sn_{0.5}I₃, or FA_{0.7}MA_{0.3}Pb_{0.5}Sn_{0.5}I₃, which is not limited herein.

The thickness of the second light absorption layer 142 is not particularly limited, and may be the light absorption layer thickness commonly used in the art.

The second electron transport layer 143 is made of a material including an electron transport material. The present disclosure does not particularly limit the electron transport material included in the second electron transport layer 143. For example, the electron transport material includes at least one of fullerene and its derivative (for example, C₆₀), metal oxide (such as oxide containing at least one of magnesium, cadmium, zinc, indium, lead, tungsten, bismuth, mercury, titanium, silver, manganese, iron, and vanadium), silicon oxide, strontium titanate, calcium titanate, lithium fluoride, and calcium fluoride.

The electron barrier layer 144 is arranged between the second light absorption layer 142 and the second hole transport layer 141 and is configured to block electrons generated by excitation in the second light absorption layer 142.

In some embodiments, the electron barrier layer 144 is arranged as a film layer structure. By arranging the electron barrier layer as a film layer structure, the transport of electrons can be further blocked. In other embodiments, the electron barrier layer 144 is arranged as island-distributed nanoparticles. By arranging the electron barrier layer 144 as island-distributed nanoparticles, the lateral transport of holes can be reduced, which helps improve the utilization of holes. Optionally, the electron barrier layer 144 is arranged as island-distributed nanoparticles.

The term "nanoparticles" in the present disclosure refers to particles with a size (particle size) at a nanometer level. The nanoparticles may be in at least one of a spherical shape, approximately spherical shape, and polyhedral shape. For example, the nanoparticles are in at least one of a spherical shape, oblate spherical shape, and prolate ellipsoidal shape.

In some embodiments, the median particle size of the nanoparticles is 1 nm to 30 nm. Optionally, the particle size of the nanoparticles is 1 nm to 20 nm. Further optionally, the particle size of the nanoparticles is 5 nm to 20 nm. For example, the median particle size of the nanoparticles is 1 nm, 2 nm, 4 nm, 6 nm, 8 nm, 10 nm, 12 nm, 14 nm, 16 nm, 18 nm, 20 nm, 25 nm, 30 nm, or a value between any two numerical values, but is not limited thereto. By setting the median particle size of the nanoparticles to the above range, the aggregation of the nanoparticles can be alleviated, which helps further reduce the lateral transport of holes.

In some embodiments, a resistivity of the electron barrier layer 144 is greater than or equal to 10¹² Ω·m. For example, the resistivity of the electron barrier layer 144 is 10¹² Ω·m, 2×10¹² Ω·m, 3×10¹² Ω·m, 4×10¹² Ω·m, 5×10¹² Ω·m, 6×10¹² Ω·m, 7×10¹² Ω·m, 8×10¹² Ω·m, 9×10¹² Ω·m, 10×10¹² Ω·m, 10¹⁴ Ω·m, 10¹⁵ Ω·m, 10¹⁶ Ω·m, 10¹⁷ Ω·m, 10¹⁸ Ω·m, or a value between any two numerical values, but is not limited thereto. The above electron barrier layer 144 has a strong electron blocking effect. In some embodiments, the resistivity of the electron barrier layer 144 is greater than or equal to 10¹² Ω·m and less than or equal to 10¹⁸ Ω·m.

In some embodiments, the material used for the electron barrier layer 144 includes at least one of inorganic electron blocking materials and organic electron blocking materials. The inorganic electron blocking material includes at least one of inorganic oxide, inorganic nitride, inorganic carbide, inorganic silicide, inorganic sulfide, and carbon material. For example, the material used for the electron barrier layer 144 includes at least one of antimony oxide, aluminum oxide, cobalt oxide, boron oxide, bismuth oxide, chromium trioxide, copper oxide, magnesium oxide, molybdenum trioxide, silicon dioxide, vanadium oxide, zirconium oxide, aluminum nitride, aluminum nitride, boron nitride, calcium nitride, chromium nitride, europium nitride, magnesium nitride, silicon nitride, titanium nitride, vanadium nitride, zirconium nitride, gallium nitride, aluminum carbide, boron carbide, chromium carbide, molybdenum carbide, silicon carbide, titanium carbide, vanadium carbide, tungsten carbide, zirconium carbide, cobalt silicide, magnesium silicide, molybdenum silicide, niobium silicide, titanium silicide, tungsten silicide, zirconium silicide, aluminum sulfide, antimony sulfide, bismuth sulfide, barium sulfide, boron sulfide, calcium sulfide, chromium sulfide, cobalt sulfide, europium sulfide, gallium sulfide, magnesium sulfide, molybdenum sulfide, silicon disulfide, tungsten sulfide, vanadium sulfide, and zirconium sulfide. For example, the organic electron blocking material includes at least one of diphenylamino carbazole and methyl triphenylamine carboxylic acid.

In some embodiments, the material of the electron barrier layer 144 includes one or more of aluminum oxide, molybdenum oxide, silicon oxide, magnesium nitride, tungsten sulfide, molybdenum silicide, and boron carbide.

In some embodiments, the thickness of the electron barrier layer 144 is 1 nm to 25 nm, optionally 1 nm to 20 nm, and more optionally 5 nm to 20 nm. For example, the thickness of the electron barrier layer 144 is 1 nm, 2 nm, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, 22 nm, 25 nm, or a value between any two numerical values, but is not limited thereto. By setting the thickness of the electron barrier layer 144 to the above range, the electron barrier layer 144 can exert the electron blocking effect while incurring low light absorption, which helps reduce the absorption of sunlight by the electron barrier layer 144.

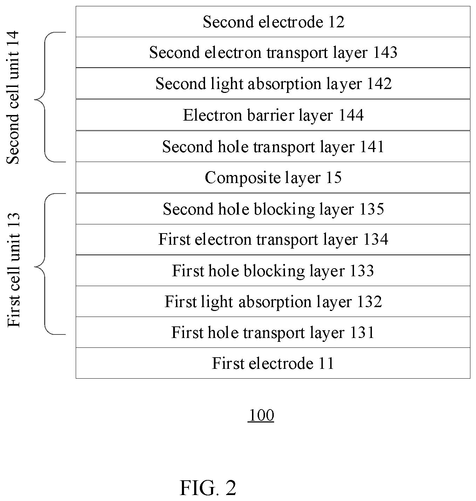

According to the present disclosure, FIG. 2 for example shows a structural diagram of a tandem solar cell 100 according to another embodiment. In this embodiment, the first cell unit 13 is arranged on the first electrode 11 and includes a first hole transport layer 131, a first light absorption layer 132, a first hole blocking layer 133, a first electron transport layer 134, and a second hole blocking layer 135 arranged sequentially along the first direction. According to a specific example, the first light absorption layer includes a perovskite material. The composite layer 15 is arranged on the second hole blocking layer 135. The second cell unit is arranged on the composite layer 15. With the first hole blocking layer 133 and the second hole blocking layer 135, multi-layer blocking of holes in the first cell unit 13 can be realized, the hole blocking effect can be strengthened, and the non-radiative recombination of holes and electrons can be further reduced, thereby optimizing the open circuit voltage and improving photoelectric conversion efficiency of the tandem solar cell.

The first hole transport layer 131 is arranged on the first electrode 11 and includes a hole transport material. The present disclosure does not particularly limit the hole transport material included in the first hole transport layer 131. For example, the first hole transport layer 131 includes at least one of inorganic hole transport material and organic hole transport material. For example, the inorganic hole transport material includes at least one of metal oxide and copper thiocyanate. For example, the metal oxide includes tin oxide (SnOₓ, where 1<x<2), nickel oxide (NiOₓ, 1≤x≤2), and copper oxide (Cu₂O). The specific examples of the organic hole transport material are the same as the organic hole transport materials in the above embodiments and are not repeated herein.

The first light absorption layer 132 is arranged on the first hole transport layer 131 and is made of a material including a perovskite material. In order to improve the photoelectric conversion efficiency, the first light absorption layer 132 includes a perovskite material (hereinafter may be referred to as a first perovskite material) designed to have a relatively wider bandgap. The first perovskite material is well known to those skilled in the art. For example, the first perovskite material includes FA_{0.8}Cs_{0.2}Pb(I_{0.6}Br_{0.4})₃, FA_{0.15}Cs_{0.85}Pb(I_{0.73}Br_{0.27})₃, and Cs0.12MA0.05FA0.83Pb(I0.6Br0.4)3.

In some embodiments, the tandem solar cell is a laminated cell containing a perovskite material, which may be a laminated cell formed by perovskite and other solar cells, such as a perovskite-gallium arsenide tandem solar cell and a perovskite-gallium phosphide tandem solar cell, where the perovskite cell is the second cell unit. In other embodiments, the tandem solar cell is an all-perovskite tandem solar cell, that is, a perovskite-perovskite tandem solar cell, where both the first light absorption layer 132 and the second light absorption layer 142 include perovskite materials. Perovskite materials have high photoelectric conversion efficiency. Compared with other tandem solar cells, the photoelectric conversion efficiency of the all-perovskite tandem solar cell is further improved.

In some embodiments, a bandgap of the perovskite material in the first light absorption layer 132 is wider than a bandgap of the perovskite material in the second light absorption layer 142. In this way, the first light absorption layer 132 helps to absorb short-wavelength light, and the second light absorption layer 142 helps to absorb long-wavelength light. The two can increase a spectral width for light absorption of the tandem solar cell and improve the photoelectric conversion efficiency of the tandem solar cell. For example, the bandgap of the first perovskite material is 1.6 eV to 2.3 eV, and the bandgap of the second perovskite material is 1.1 eV to 1.4 eV.

The first hole blocking layer 133 is arranged on the first light absorption layer 132 and includes a first hole blocking layer material. Conventional hole blocking materials can be used for the first hole blocking material, but the difference between the HOMO energy level of the first hole blocking material and the HOMO energy level of the first perovskite material is less than 0. For example, the first hole blocking material includes at least one of 2,9-dimethyl-4,7-diphenyl-1,10-phenanthroline (BCP), SnO₂, 1,3,5-tris(1-phenyl-1H-benzimidazol-2-yl)benzene (TPBI), 1,3-bis(3,5-dipyridin-3-ylphenyl)benzene (B3PyPB), diphenyl[4-(triphenylsilyl)phenyl]phosphine oxide (TSPO1), 2,7-bis(2,2'-bipyridin-5-yl)triphenylene (BPy-TP2), bis(8-hydroxy-2-methylquinoline)-(4-phenylphenoxy)aluminum, (6-(1,10-phenanthrolin-3-yl)naphthalen-2-yl)diphenylphosphine oxide (Phen-NaDPO), 3-(biphenyl-4-yl)-5-(4-tert-butylphenyl)-4-phenyl-4H-1,2,4-triazole, 2-(4-tert-butylphenyl)-5-(4-biphenylyl)-1,3,4-oxadiazole, 3,5-diphenyl-4-(1-naphthyl)-1H-1,2,4-triazole, and benzophenanthroline.

The first electron transport layer 134 is arranged on the first hole blocking layer 133 and includes an electron transport material. The present disclosure does not particularly limit the electron transport material included in the first electron transport layer 134. The specific examples of the electron transport material included in the first electron transport layer 134 are the same as those in the above embodiments and are not be repeated herein.

The second hole blocking layer 135 is arranged on the first electron transport layer 134 and includes a second hole blocking layer material. Conventional hole blocking materials can be used for the second hole blocking material. For example, the second hole blocking material may include at least one of 2,9-dimethyl-4,7-diphenyl-1,10-phenanthroline (BCP), fullerene and its derivative (for example, PCBM), SnO_{z} (1.5≤z≤2), and SnO₂.

In some embodiments, the second cell unit further includes a third hole blocking layer arranged between the second light absorption layer and the second electron transport layer. The blocking effect of the third hole blocking layer on holes can further reduce the non-radiative recombination of electrons and holes.

The third hole blocking layer includes a third hole blocking material. Conventional hole blocking materials can be used for the third hole blocking material, but the difference between the HOMO energy level of the third hole blocking material and the HOMO energy level of the second light absorption material is less than 0. In some embodiments, the third hole blocking material may be the same as the first hole blocking material. In some embodiments, the third hole blocking material may further include at least one of CuPc, 8-hydroxyquinoline-lithium, and BN-ICz-1 (C₅₀H₄₀BN₃).

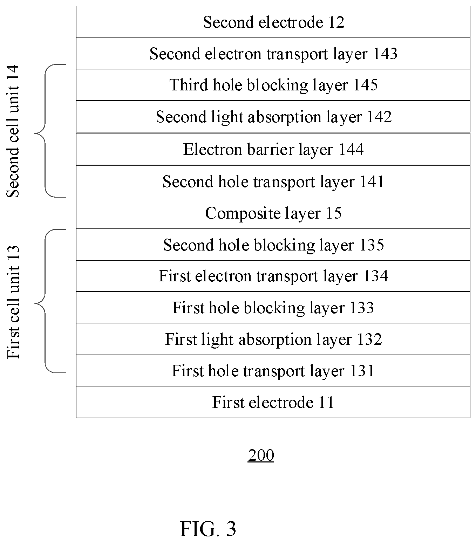

According to an embodiment, FIG. 3 is a structural diagram of an example tandem solar cell 200 in this embodiment. In this embodiment, the first cell unit 13 is arranged on the first electrode 11 and includes a first hole transport layer 131, a first light absorption layer 132, a first hole blocking layer 133, a first electron transport layer 134, and a second hole blocking layer 135 arranged sequentially along the first direction. The second cell unit 14 is arranged on the composite layer 15 and includes a second hole transport layer 141, an electron barrier layer 144, a second light absorption layer 142, a third hole blocking layer 145, and a second electron transport layer 143 arranged sequentially along the first direction. The second electrode 12 is arranged on the second electron transport layer 143. With the first hole blocking layer 133, the second hole blocking layer 135, and the third hole blocking layer 145, multi-layer blocking of holes can be realized, and the hole blocking effect can be strengthened, thereby further the optimizing open circuit voltage and improving photoelectric conversion efficiency of the tandem solar cell.

In this embodiment, the other layers are the same as those in the foregoing embodiments and are not repeated herein.

In some embodiments, the second cell unit further includes a fourth hole blocking layer arranged between the second electron transport layer and the second electrode. The blocking effect of the fourth hole blocking layer on holes further reduces the non-radiative recombination of electrons and holes.

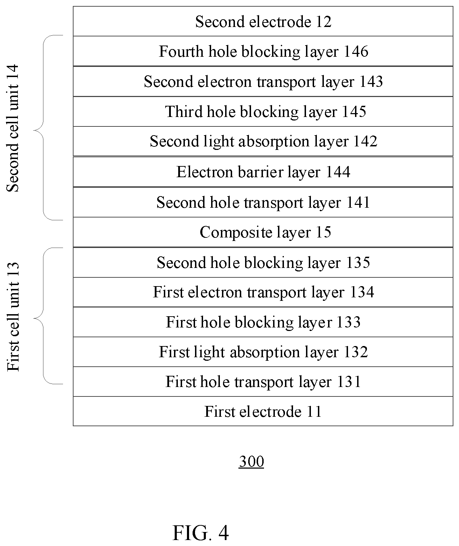

According to an embodiment, FIG. 4 is a structural diagram of an example tandem solar cell 300 in this embodiment. In this embodiment, the first cell unit 13 is arranged on the first electrode 11 and includes a first hole transport layer 131, a first light absorption layer 132, a first hole blocking layer 133, a first electron transport layer 134, and a second hole blocking layer 135 arranged sequentially along the first direction. The composite layer 15 is arranged on the second hole blocking layer 135, and the second cell unit 14 is arranged on the composite layer 15. The second cell unit 14 includes a second hole transport layer 141, an electron barrier layer 144, a second light absorption layer 142, a third hole blocking layer 145, a second electron transport layer 143, and a fourth hole blocking layer 146 that are sequentially stacked. The second electrode 12 is arranged on the fourth hole blocking layer 146. In this embodiment, with the first hole blocking layer 133, the second hole blocking layer 135, the third hole blocking layer 145, and the fourth hole blocking layer 146, multi-layer blocking of holes can be realized, and the hole blocking effect can be strengthened, thereby further optimizing the open circuit voltage and improving photoelectric conversion efficiency of the tandem solar cell.

The fourth hole blocking layer 146 includes a fourth hole blocking material. The present disclosure does not particularly limit the fourth hole blocking material. For example, the fourth hole blocking material may include at least one of fullerene and its derivative (for example, C₆₀), SnOz (1.5≤z≤2), and bathocuproine (BCP). The fourth hole blocking material may be the same as or different from the second hole blocking material.

In this embodiment, the other layers are the same as those in the foregoing embodiments and are not repeated herein.

The present disclosure does not particularly limit the preparation method of the functional layers of the above tandem solar cell, and may include preparation methods used in the art. For example, the above functional layers are formed by means including evaporation, atomic layer deposition, spin coating, and the like.

In some embodiments, the preparation method of the above tandem solar cell includes the following steps S10 to S30.

S10. Prepare a first cell unit 13 on the first electrode 11.

S20. Prepare a composite layer 15 on the first cell unit 13.

S30. Prepare a second hole transport layer 141, an electron barrier layer 144, a second light absorption layer 142, and a second electron transport layer 143 sequentially on a side of the composite layer 15 facing away from the first cell unit 13 to obtain a second cell unit 14.

S30. Prepare a second electrode 12 on a side of the second electron transport layer 143 facing away from the second light absorption layer 142.

The film layers can be prepared by using methods known to those skilled in the art to obtain a tandem solar cell. The specific implementations of the film layers are not limited, and a specific implementation can be determined based on the above structure. For example, based on the different film layers, methods such as spray coating, sputtering, and vapor deposition can be selectively used, and means that can be realized by those skilled in the art can be used.

Further, the vapor deposition method includes at least one of chemical vapor deposition, physical vapor deposition, plasma vapor deposition, and atomic layer deposition.

In some embodiments, the electron barrier layer 144 is prepared by using an atomic layer deposition method or a liquid phase method (such as spin coating, slot-die coating, or spray coating), which is not limited herein. Generally, an electron barrier layer 144 prepared by using the atomic layer deposition method is generally a dense film layer structure, and an electron barrier layer 144 prepared by using the liquid phase method is generally a film layer formed by island-distributed nanoparticles.

The embodiments of the present disclosure also provide a photovoltaic module. Generally, the photovoltaic module includes the above tandem solar cell, a ribbon connecting multiple tandem solar cells, a junction box for current transmission, and a battery encapsulation component.

In some embodiments, the battery encapsulation component includes photovoltaic glass. The photovoltaic glass covers the above tandem solar cell and protects the tandem solar cell. Further, the photovoltaic glass is featured by good light transmittance and high hardness, and can adapt to large day-night temperature differences and harsh weather conditions.

In some embodiments, the battery encapsulation component includes an ethylene-vinyl acetate (EVA) copolymer film, which is arranged between the photovoltaic glass and the tandem solar cell and is used to bond the photovoltaic glass and the solar cell.

In some embodiments, the battery encapsulation component includes a photovoltaic backsheet. The backsheet also protects the tandem solar cell.

Optionally, a material of the photovoltaic backsheet may be a polyvinyl fluoride composite film or a thermoplastic elastomer material. The material of the photovoltaic backsheet has the properties of insulation, waterproofing, and aging resistance.

In some embodiments, the battery encapsulation component includes a solar aluminum frame, including an aluminum alloy material and has properties such as high strength and good corrosion resistance. It supports and protects the solar cell.

The embodiments of the present disclosure further provide a power generation apparatus, including the tandem solar cell provided in the above embodiments.

The embodiments of the present disclosure further provide an electric apparatus, including the tandem solar cell provided in the above embodiments.

In some embodiments, the electric apparatus may alternatively be a lighting device, an energy storage device, and the like. The embodiments of the present disclosure include but are not limited to this. For example, the electric apparatus may be a solar water heater, a solar street light, a solar photovoltaic generator, or the like.

### Example 1

### Preparation of tandem solar cell

(1) A first electrode was provided: FTO conductive glass with a specification of 2.0 cm×2.0 cm was used. FTO with a width of 0.35 cm was removed from each of two ends by laser etching, thereby exposing the glass substrate. The etched FTO conductive glass was ultrasonically cleaned with a cleaning solution, deionized water, and ethanol sequentially. The solvent on the FTO conductive glass was blown dry using a nitrogen gun, and the FTO conductive glass was then placed in an ultraviolet-ozone cleaner for further cleaning.
(2) A first hole transport layer was provided. The FTO conductive glass after ultraviolet-ozone treatment was spin-coated with 15 mg/mL NiOₓ (1≤x≤2) nanoparticle aqueous solution in a glove box at a rate of 2000 rpm/s to form a first hole transport layer with a thickness of 30 nm. Thermal annealing was then performed at 150°C for 10 min.
(3) A first light absorption layer was provided: 1659 mg of lead iodide, 880 mg of lead bromide, 240 mg of formamidinium bromide, 495 mg of formamidinium iodide, 187 mg of cesium iodide, and 102 mg of cesium bromide were dissolved in 1 mL of a mixed solution of N,N-dimethylformamide (DMF) and dimethyl sulfoxide (DMSO) (volume ratio of DMF to DMSO was 4:1); stirred for 1 h; and filtered with a 0.22 µm organic filter film to obtain a perovskite precursor solution. 100 µL of the perovskite precursor solution was used to spin-coat the first hole transport layer at 5000 rpm, then was placed in a vacuum flash evaporator for 30s; and transferred to a hot plate at 100°C for annealing for 10 min to form a first light absorption layer (FA_{0.8}Cs_{0.2}Pb(I_{0.6}Br_{0.4})₃) with a thickness of 500 nm.
(4) A first electron transport layer was provided: SnO₂ was deposited with a thickness of 20 nm on the above first light absorption layer by ALD as the first electron transport layer.
(5) A composite layer was provided: A composite layer was provided: Au with a thickness of 1 nm was evaporated on the second hole blocking layer as a composite layer.
(6) A second hole transport layer was provided: The above composite layer was spin-coated with a mixed solution of poly(3,4-ethylenedioxythiophene) and polystyrene sulfonate at a spin-coating speed of 3000 rpm for 20s, then transferred to a hot plate and annealed at 150°C for 15 min to form a second hole transport layer with a thickness of 10 nm.
(7) An electron barrier layer was provided: Al₂O₃ with a thickness of 10 nm was deposited on the above second hole transport layer by atomic layer deposition as an electron barrier layer.
(8) A second light absorption layer was provided: 2 mg of formamidinium iodide, 85 mg of methylammonium iodide, 4 mg of lead iodide, and 335 mg of tin iodide were added to 1 mL of a mixed solvent of DMF and DMSO (volume ratio of DMF to DMSO was 2:1), stirred at 600 rpm on a magnetic stirrer for 2 h, and filtered to obtain a perovskite precursor solution. The second hole transport layer was spin-coated with 100 µL of the above perovskite precursor solution first at a spin-coating speed of 1000 rpm and an acceleration of 200 rpm/s for 10s and then at a spin-coating speed of 3000 rpm and an acceleration of 1000 rpm/s for 20s. 500 µL of ethyl acetate was added dropwise to the perovskite precursor solution for spin-coating, and then the perovskite precursor solution was again used for spin-coating at a spin-coating speed of 4000 rpm for 20s, then transferred to a hot plate and annealed at 100°C for 10 min to form a second light absorption layer (FA_{0.7}MA_{0.3}Pb_{0.5}Sn_{0.5}I₃) with a thickness of 1 µm.
(9) A second electron transport layer was provided: The second light absorption layer was spin-coated with a 15 mg/mL chlorobenzene solution of a fullerene derivative (PCBM) to form a second electron transport layer with a thickness of 10 nm.
(10) A second electrode was provided: Metal copper (Cu) with a thickness of 100 nm was evaporated on the above second electron transport layer as the second electrode.

### Example 2

The difference from Example 1 lied in that step (7) was replaced with the following operation.

(7) An electron barrier layer was provided: On the second hole transport layer, a 5 mg/ml MoO₃ nanoparticle (median particle size of 17.3 nm) aqueous solution was used for spin-coating at a spin-coating rate of 3000 rpm for 20s, followed by annealing at 100°C for 10 min to obtain an electron barrier layer MoO₃ with a thickness of 18.2 nm.

### Example 3

The difference from Example 1 lied in that step (7) was replaced with the following operation.

(7) An electron barrier layer was provided: On the second hole transport layer, a 6.5 mg/ml SiO₂ nanoparticle (median particle size of 10.5 nm) aqueous solution was used for spin-coating at a spin-coating rate of 3000 rpm for 20s, followed by annealing at 100°C for 10 min to obtain an electron barrier layer SiO₂ with a thickness of 12.3 nm.

### Example 4

The difference from Example 1 lied in that step (7) was replaced with the following operation.

(7) An electron barrier layer was provided: On the second hole transport layer, a 3.5 mg/ml Mg₃N₂ nanoparticle (median particle size of 19.8 nm) aqueous solution was used for spin-coating at a spin-coating rate of 3000 rpm for 20s, followed by annealing at 100°C for 10 min to obtain an electron barrier layer Mg₃N₂ with a thickness of 20.8 nm.

### Example 5

The difference from Example 1 lied in that step (7) was replaced with the following operation.

(7) An electron barrier layer was provided: On the second hole transport layer, a 5 mg/ml WS₂ nanoparticle (median particle size of 12.1 nm) aqueous solution was used for spin-coating at a spin-coating rate of 3000 rpm for 20s, followed by annealing at 100°C for 10 min to obtain an electron barrier layer WS₂ with a thickness of 13.0 nm.

### Example 6

The difference from Example 1 lied in that step (7) was replaced with the following operation.

(7) An electron barrier layer was provided: On the second hole transport layer, a 2.5 mg/ml MoSi₂ nanoparticle (median particle size of 15.6 nm) aqueous solution was used for spin-coating at a spin-coating rate of 3000 rpm for 20s, followed by annealing at 100°C for 10 min to obtain an electron barrier layer MoSi₂ with a thickness of 17.3 nm.

### Example 7

The difference from Example 1 lied in that step (7) was replaced with the following operation.

(7) An electron barrier layer was provided: On the second hole transport layer, a 1.5 mg/ml B₄C nanoparticle (median particle size of 18.2 nm) aqueous solution was used for spin-coating at a spin-coating rate of 3000 rpm for 20s, followed by annealing at 100°C for 10 min to obtain an electron barrier layer B₄C with a thickness of 19.0 nm.

### Example 8

The difference from Example 1 lied in that step (7) was replaced with the following operation.

(7) An electron barrier layer was provided: On the second hole transport layer, a 3.5 mg/ml Al₂O₃ nanoparticle (median particle size of 14.7 nm) aqueous solution was used for spin-coating at a spin-coating rate of 3000 rpm for 20s, followed by annealing at 100°C for 10 min to obtain an electron barrier layer Al₂O₃ with a thickness of 15.5 nm.

### Comparative example 1

A tandem solar cell was prepared according to the method of Example 1, with the difference that no electron barrier layer was formed.

### Performance test of tandem solar cell

### Open circuit voltage (Voc) and photoelectric conversion efficiency (PCE) test of tandem solar cell

In an atmospheric environment, an AM1.5G standard light source was used as a solar simulation light source, and a four-channel digital source meter (Keithley 2440) was used to measure a voltammetric characteristic curve of the cell under light source irradiation. According to the voltammetric characteristic curve, the open circuit voltage, short-circuit current density (Jsc), and passivation factor FF (Fill Factor) of the photovoltaic parameters of the tandem solar cell were obtained. $\begin{matrix}PCE = Pout / Popt \\ = Voc \times Jsc \times \left(Vmpp\times Jmpp\right) / \left(Voc\times Jsc\right) \\ = Voc \times Jsc \times FF / Popt\end{matrix}$

Pout, Popt, Vmpp, and Jmpp were the battery operation output power, incident light power, battery maximum power point voltage, and maximum power point current respectively.

The tandem solar cells obtained in Examples 1 to 8 and Comparative example 1 were subjected to performance tests, and the test results were shown in Table 1.

**Table 1**

| Serial number | Electron barrier layer material | Electron barrier layer thickness (nm) | Median particle size (nm) | Voc (V) | PCE (%) |
|---|---|---|---|---|---|
| Example 1 | Al₂O₃ | 10 | - | 2.032 | 26.45 |
| Example 2 | MoO₃ | 18.2 | 17.3 | 2.024 | 26.29 |
| Example 3 | SiO₂ | 12.3 | 10.5 | 2.021 | 26.12 |
| Example 4 | Mg₃N₂ | 20.8 | 19.8 | 2.028 | 26.35 |
| Example 5 | WS₂ | 13.0 | 12.1 | 2.042 | 26.38 |
| Example 6 | MoSi₂ | 17.3 | 15.6 | 2.017 | 26.54 |
| Example 7 | B₄C | 19.0 | 18.2 | 2.034 | 26.33 |
| Example 8 | Al₂O₃ | 15.5 | 14.7 | 2.029 | 26.38 |
| Comparative example 1 | - | - | - | 1.998 | 25.96 |

As can be learned from Table 1, the perovskite tandem solar cell prepared in Example 1 has an electron barrier layer arranged between the second hole transport layer and the second light absorption layer. Compared with the perovskite tandem solar cell prepared in Comparative example 1, the perovskite tandem solar cell prepared in Example 1 has optimized open circuit voltage and improved photoelectric conversion efficiency.

It should be noted that the present disclosure is not limited to the above embodiments. The above embodiments are only examples. Embodiments that have substantially the same structure as the technical idea and exert the same effect within the scope of the technical solution of the present disclosure are all included in the technical scope of the present disclosure. In addition, without departing from the gist of the present disclosure, various modifications that can be conceived by those skilled in the art to the embodiments, and other ways constructed by combining some components in the embodiments are also included in the scope of the present disclosure.

## Claims

1. A tandem solar cell, wherein the tandem solar cell comprises a first electrode and a second electrode, at least two cell units arranged between the first electrode and the second electrode, and a composite layer;
the at least two cell units comprise a first cell unit and a second cell unit arranged sequentially along a first direction, and the composite layer is arranged between the first cell unit and the second cell unit, wherein the first direction is a light incident direction;
wherein the second cell unit comprises a second hole transport layer, a second light absorption layer, and a second electron transport layer that are arranged sequentially; and
the second cell unit further comprises an electron barrier layer arranged between the second hole transport layer and the second light absorption layer.

2. The tandem solar cell according to claim 1, wherein a thickness of the electron barrier layer is 1 nm to 25 nm.

3. The tandem solar cell according to claim 2, wherein the thickness of the electron barrier layer is 1 nm to 20 nm.

4. The tandem solar cell according to claim 3, wherein the thickness of the electron barrier layer is 5 nm to 20 nm.

5. The tandem solar cell according to claim 1, wherein the electron barrier layer is arranged as a film layer structure or is island-distributed nanoparticles.

6. The tandem solar cell according to claim 5, wherein a median particle size of the nanoparticles is 1 nm to 30 nm.

7. The tandem solar cell according to claim 6, wherein the median particle size of the nanoparticles is 1 nm to 20 nm.

8. The tandem solar cell according to claim 7, wherein the median particle size of the nanoparticles is 5 nm to 20 nm.

9. The tandem solar cell according to any one of claims 1 to 8, wherein a thickness of the second hole transport layer is 5 nm to 10 nm.

10. The tandem solar cell according to claim 1, wherein the first cell unit is arranged on the first electrode and comprises a first hole transport layer, a first light absorption layer, a first hole blocking layer, a first electron transport layer, and a second hole blocking layer that are arranged sequentially along the first direction.

11. The tandem solar cell according to any one of claims 1 to 8, wherein the second cell unit further comprises a third hole blocking layer arranged between the second light absorption layer and the second electron transport layer.

12. The tandem solar cell according to any one of claims 1 to 8, wherein the second cell unit further comprises a fourth hole blocking layer arranged between the second electron transport layer and the second electrode.

13. The tandem solar cell according to any one of claims 1 to 8, wherein a resistivity of the electron barrier layer is greater than or equal to 10¹² Ω·m.

14. The tandem solar cell according to any one of claims 1 to 8, wherein a thickness of the electron barrier layer is greater than or equal to 10¹² Ω·m and less than or equal to 10¹⁸ Ω·m.

15. The tandem solar cell according to any one of claims 1 to 8, wherein a material of the electron barrier layer comprises at least one of an inorganic electron blocking material and an organic electron blocking material.

16. The tandem solar cell according to claim 15, wherein the material of the electron barrier layer comprises at least one of an inorganic oxide, an inorganic nitride, an inorganic carbide, an inorganic silicide, an inorganic sulfide, and a carbon material.

17. The tandem solar cell according to claim 16, wherein the tandem solar cell satisfies one or more of the following conditions:
(1) the inorganic oxide comprises one or more of antimony oxide, aluminum oxide, cobalt oxide, boron oxide, bismuth oxide, chromium trioxide, copper oxide, magnesium oxide, molybdenum trioxide, silicon dioxide, vanadium oxide, and zirconium oxide;
(2) the inorganic nitride comprises one or more of aluminum nitride, aluminum nitride, boron nitride, calcium nitride, chromium nitride, europium nitride, magnesium nitride, silicon nitride, titanium nitride, vanadium nitride, zirconium nitride, and gallium nitride;
(3) the inorganic carbide comprises one or more of aluminum carbide, boron carbide, chromium carbide, molybdenum carbide, silicon carbide, titanium carbide, vanadium carbide, tungsten carbide, and zirconium carbide;
(4) the inorganic silicide comprises one or more of cobalt silicide, magnesium silicide, molybdenum silicide, niobium silicide, titanium silicide, tungsten silicide, and zirconium silicide;
(5) the inorganic sulfide comprises one or more of aluminum sulfide, antimony sulfide, bismuth sulfide, barium sulfide, boron sulfide, calcium sulfide, chromium sulfide, cobalt sulfide, europium sulfide, gallium sulfide, magnesium sulfide, molybdenum sulfide, silicon disulfide, tungsten sulfide, vanadium sulfide, and zirconium sulfide; and
(6) the organic electron blocking material comprises one or more of diphenylamino carbazole and methyl triphenylamine carboxylic acid.

18. The tandem solar cell according to any one of claims 1 to 8, wherein a bandgap of the second light absorption layer is narrower than a bandgap of the first light absorption layer.

19. The tandem solar cell according to claim 18, wherein the tandem solar cell satisfies one or more of the following conditions:
(1) the first light absorption layer comprises a perovskite material;
(2) the bandgap of the first light absorption layer is 1.6 eV to 2.3 eV;
(3) the second light absorption layer comprises a perovskite material; and
(4) the bandgap of the second light absorption layer is 1.1 eV to 1.4 eV.

20. A photovoltaic module, wherein the photovoltaic module comprises the tandem solar cell according to any one of claims 1 to 19.

21. A power generation apparatus, wherein the power generation apparatus comprises the tandem solar cell according to any one of claims 1 to 19.

22. An electric apparatus, wherein the electric apparatus comprises the tandem solar cell according to any one of claims 1 to 19.
